# EUROPEAN PATENT APPLICATION

(11) **EP 3 547 351 A1**
(43) Date of publication of application: **02.10.2019**
(21) Application number: 16922321.1
(22) Date of filing: 23.11.2016
(51) Int. Cl.: H01L 21/336, H01L 29/786

(54) **ARRAY SUBSTRATE AND MANUFACTURING METHOD THEREFOR**

(71) Applicant: Shenzhen Royole Technologies Co., Ltd., Shenzhen, Guangdong 518172 (CN)
(72) Inventor: LI, Wenhui, Shenzhen Guangdong 518052 (CN)
(74) Representative: Mewburn Ellis LLP
(86) International application number: PCT/CN2016/106887
(87) International publication number: WO 2018/094596

(57) **Abstract**

A method for manufacturing an array substrate is provided. The method includes forming a gate electrode (20), a gate insulating layer (30), a conductor buffer layer (40), and a metal layer (50) on a substrate (10) in sequence; patterning the metal layer (50) and the conductor buffer layer (40) to form a source electrode (51), a drain electrode (52), and a channel (53) disposed therebetween, a portion of the conductor buffer layer (40) exposed to the channel (53); and semiconductorizing the portion of the conductor buffer layer (50) exposed to the channel (53) to form a semiconductor region (41) in the channel (53). In the method, the metal oxide semiconductor layer in the existing array substrate structure is omitted, thereby reducing the manufacturing cost. In addition, it is not necessary to etch the conductor buffer layer during the formation of the channel, which simplifies the etching process, thereby reducing the etching difficulty and further reducing the manufacturing cost of the array substrate.

## Description

### TECHNICAL FIELD

The present disclosure relates to the field of display technologies, and more particularly relates to an array substrate and a method for manufacturing the array substrate.

### BACKGROUND

Thin film transistor (TFT) array substrates are widely used in different types of display devices. In an existing array substrate, a source-drain layer is formed on a semiconductor layer. The source-drain layer includes a metal layer and a conductor buffer layer. The metal layer and the semiconductor layer are separated by the conductor buffer layer. In this way, the metal layer of the source-drain layer is prevented from diffusing into the semiconductor layer to reduce the contact resistance between the metal layer and the semiconductor layer, and defects such as metal puncture are avoided.

During the formation of channels in the array substrate, the metal layer and the conductor buffer layer need to be sequentially etched to expose the semiconductor layer. Therefore, the existing etching process is complicated and difficult, to cause the manufacturing cost of the array substrate to remain high.

### SUMMARY

The purpose of the present disclosure is to provide a method for manufacturing an array substrate capable of simplifying the etching process and reducing the manufacturing cost of the array substrate.

Another object of the present disclosure is to provide an array substrate manufactured by the above manufacturing method.

To achieve the above objective, the present disclosure provides the following technical solutions.

An embodiment of the present disclosure provides a method for manufacturing an array substrate. The method includes forming a gate electrode, a gate insulating layer, a conductor buffer layer, and a metal layer on a substrate in sequence; patterning the metal layer and the conductor buffer layer to form a source electrode, a drain electrode, and a channel disposed therebetween, a portion of the conductor buffer layer exposed to the channel; and semiconductorizing the portion of the conductor buffer layer exposed to the channel to form a semiconductor region in the channel.

Therein, patterning the metal layer and the conductor buffer layer to form a source electrode, a drain electrode, and a channel disposed therebetween, a portion of the conductor buffer layer exposed to the channel includes coating a photoresist on the metal layer; providing a multi-gray mask, and patterning the photoresist by the multi-gray mask to form a half-exposure region on the photoresist; etching the metal layer and the conductor buffer layer with the photoresist as a shielding layer such that the etched metal layer and the etched conductor buffer layer have source electrode patterns and drain electrode patterns; converting the half-exposure region on the photoresist to a full-exposure region; and etching a portion of the etched metal layer exposed to the full-exposure region to form the channel and expose the conductor buffer layer.

Therein, semiconductorizing the portion of the conductor buffer layer exposed to the channel to form a semiconductor region in the channel includes treating the portion of the conductor buffer layer exposed to the channel with the photoresist as the shielding layer by a plasma treatment or a high temperature oxidation atmosphere treatment such that the portion of the conductor buffer layer exposed to the channel forms the semiconductor region.

Therein, the method further includes removing the photoresist by ashing or wet etching after the semiconductor region is formed.

Therein, converting the half-exposure region of the photoresist to a full-exposure region includes ashing the photoresist to convert the half-exposure region into the full-exposure region.

Therein, etching the metal layer and the conductor buffer layer with the photoresist as a shielding layer such that the etched metal layer and the etched conductor buffer layer have source electrode patterns and drain electrode patterns includes etching the metal layer and the conductor buffer layer with an echant.

Therein, the etchant is selected from a group consisting of H₂O₂, metal chelating agent, and organic acid.

Therein, the multi-gray mask is a half-tone mask or a gray-tone mask.

Therein, forming a gate electrode, a gate insulating layer, a conductor buffer layer, and a metal layer on a substrate in sequence includes depositing the conductor buffer layer on the gate insulating layer by sputtering or thermal evaporation.

Therein, forming a gate electrode, a gate insulating layer, a conductor buffer layer, and a metal layer on a substrate in sequence includes depositing the gate insulating layer by a plasma enhanced chemical vapor deposition (PECVD).

An embodiment of the present disclosure provides an array substrate. The substrate includes a gate electrode, a gate insulating layer, a conductor buffer layer, and a metal layer stacked on a substrate in sequence. The conductor buffer layer includes a semiconductor region and a conductor region. The metal layer includes a source electrode and a drain electrode. A channel is disposed between the source electrode and the drain electrode. The source electrode and the drain electrode face the conductor regions, respectively. The semiconductor region is exposed to the channel.

Therein, the material of the conductor buffer layer is metal oxide.

Therein, the metal oxide is IGZO.

Therein, the metal layer is made of copper or copper alloy.

In the method for manufacturing an array substrate according to the present disclosure, the source electrode, the drain electrode, and the channel disposed therebetween are formed on the metal layer, the portion of the conductor buffer layer is exposed to the channel, and the conductor buffer layer is semiconductorized to form the semiconductor region at the portion of the conductor buffer layer exposed to the channel. The source electrode and the drain electrode are electrically connected through the conductor regions and the semiconductor region in sequence. Thus, the metal oxide semiconductor layer in the existing array substrate is omitted, which reduces the manufacturing cost. In addition, it is not necessary to etch the conductor buffer layer during the formation of the channel, thereby reducing the etching difficulty and further reducing the manufacturing cost of the array substrate. The array substrate according to the present disclosure may also reduce the manufacturing cost.

### BRIEF DESCRIPTION OF THE DRAWINGS

In order to more clearly illustrate the technical solution of the embodiments of the present disclosure and the related art, the accompanying drawings required for describing the embodiments will be briefly described below. Apparently, the accompanying drawings in the following description are merely the embodiments of the present disclosure, and other drawings may be obtained by those of ordinary skill in the art according to these accompanying drawings without creative efforts.
FIG. 1 is a flow diagram illustrating a method for manufacturing an array substrate according to an embodiment of the present disclosure.
FIG. 2 to FIG. 8 are schematic diagrams illustrating the processes of the method for manufacturing an array substrate in FIG. 1.
FIG. 9 is a schematic diagram illustrating an array substrate according to an embodiment of the present disclosure.

### DETAILED DESCRIPTION OF ILLUSTRATED EMBODIMENTS

The embodiments of present disclosure will be clearly and completely described with reference to the accompanying drawings. Apparently, the embodiments in the following description are merely a part of the embodiments of the present disclosure, and not all of the embodiments. All other embodiments obtained by those of ordinary skill in the art based on the embodiments of the present disclosure without creative efforts are within the scope of the present disclosure.

The ordinal qualifier terms, "first", "second", etc., applied in the following embodiments of the present disclosure are merely for the purpose of clearly illustrating the distinctive terms of the similar features in the present disclosure, and do not represent the order of the corresponding features or the order of use.

An array substrate manufactured by a method of the present disclosure may be applied to a liquid crystal display or an organic display. A flexible display screen relating to the embodiments of the present disclosure is used for, but not limited to, a mobile phone, a tablet computer, a palmtop computer, a personal digital assistant (PDA), or an e-reader.

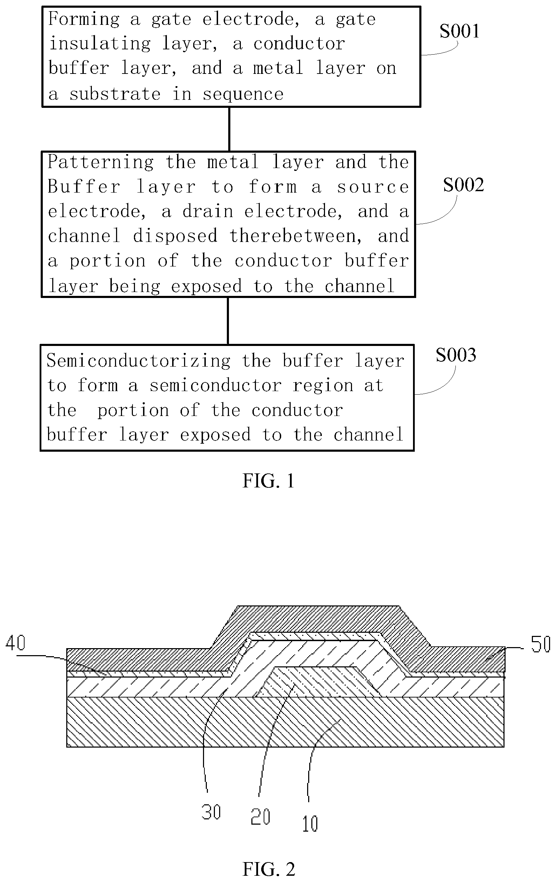

FIG. 1 illustrates a flow diagram of a method for manufacturing an array substrate according to an embodiment of the present disclosure. The manufacturing method provided by the present disclosure mainly includes operations at the following blocks.

At block S001, a gate electrode, a gate insulating layer, a conductor buffer layer, and a metal layer are formed on a substrate in sequence.

Specifically, please also referring to FIG. 2, the substrate 10 is a transparent glass substrate. A first metal thin film is deposited on the substrate 10. The material of the first metal thin film may be selected from metals or alloys, such as Cr, W, Cu, Ti, Ta, Mo, etc. The first metal thin film may also be a gate metal layer composed of a multilayer metal. Patterns of gate lines (not shown), common electrode lines (not shown), and gate electrodes 20 are formed by patterning process using an ordinary photoresist layer. Then, on the basis of this, the gate insulating layer 30 is deposited by a plasma enhanced chemical vapor deposition (PECVD) process. The material of the gate insulating layer 30 may be selected from a group consisting of an oxide, a nitride, an oxynitride, etc.

Then, the conductor buffer layer 40 is deposited on the gate insulating layer by sputtering or thermal evaporation. The conductor buffer layer 40 may be made of indium gallium zinc oxide (IGZO), HIZO, IZO, a-InZnO, a-InZnO, ZnO:F, In203:Sn, In203:Mo, Cd2SnO4, ZnO:Al, TiO2:Nb, Cd-Sn-O or other metal oxide. Preferably, the conductor buffer layer 40 may be made of IGZO.

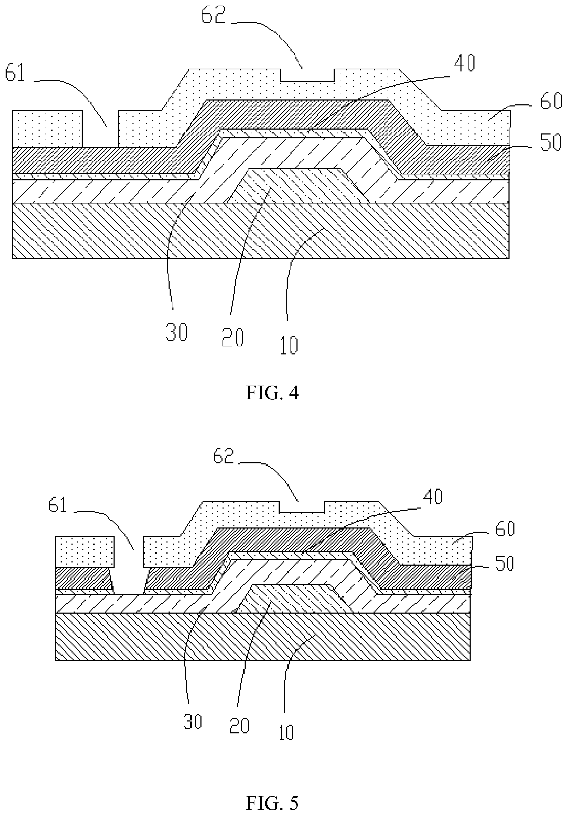

Next, the metal layer 50 is formed on the conductor buffer layer 40 by sputtering or thermal evaporation. The conductor buffer layer 40 is operated to prevent the metal layer 50 from directly contacting a semiconductor region (reference numeral 41 in FIG. 5), prevent the metal in the metal layer 50 from diffusing into the semiconductor region, and prevent defects such as metal puncture. As a result, the performance of the array substrate is improved.

At block S002, the metal layer and the conductor buffer layer are patterned to form a source electrode, a drain electrode, and a channel disposed therebetween. A portion of the conductor buffer layer is exposed to the channel.

Specifically, operations at block S002 further include operations at the blocks S0021 to S0025.

At block S0021, the metal layer 50 is coated with a photoresist 60.

At block S0022, a multi-gray mask is provided. The photoresist is patterned with the multi-gray mask to form a half-exposure region on the photoresist.

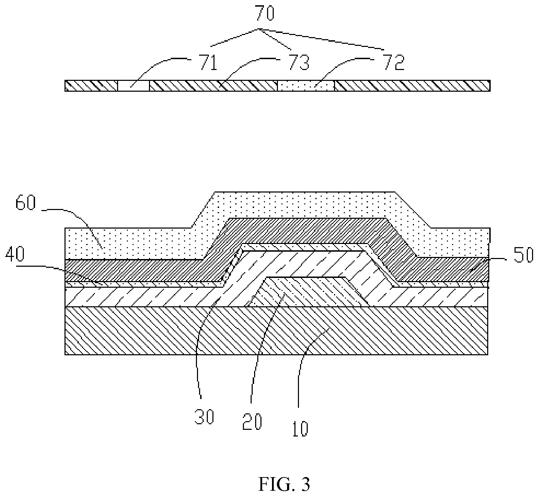

Specifically, please also referring to FIG. 3, the multi-gray mask 70 is disposed over the photoresist 60. Optionally, the multi-gray mask 70 may be a half-tone mask or a gray-tone mask. The photoresist 60 is exposed and developed (i.e., patterned). The multi-gray mask 70 includes an all-light-transmitting region 71, a semi-light-transmitting region 72, and an opaque region 73. The photoresist 60 is photoetched after the exposure light passes through the multi-gray mask 70. Please also referring to FIG. 4, the photoresist 60 under the all-light-transmitting region 71 is completely photoetched to form a full-exposure region 61 and the metal layer 50 under the full-exposure region 61 is exposed to the photoresist 60. The photoresist 60 under the semi-light-transmitting region 72 is partially photoetched to form the half-exposure region 62. The photoresist 60 under the opaque region 71 is retained. That is, the photoresist 60 is patterned to form the half-exposure region 71 thereon.

At block S0023, the metal layer and the conductor buffer layer are etched with the photoresist as a shielding layer such that the etched metal layer and the etched conductor buffer layer have a source electrode pattern and a drain electrode pattern.

Referring to FIG. 5, further specifically, an etchant may be sprayed on the photoresist 60. The metal layer 50 and the conductor buffer layer 40 are sequentially etched by the etchant through the full-exposure region 61 of the photoresist 60, until the source electrode pattern and the drain electrode pattern are formed at the metal layer 50 and the conductor buffer layer 40. Finally, the etchant is removed. Thus, the patterning the metal layer 50 is completed. It can be understood that the pattern formed by the metal layer 50 and the pattern formed by the conductor buffer layer 40 at this block are same. It can be understood that the metal layer 50 and the conductor buffer layer 40 may be etched by dry etching, which is not limited herein.

At block S0024, the half-exposure region of the photoresist is converted into the full-exposure region.

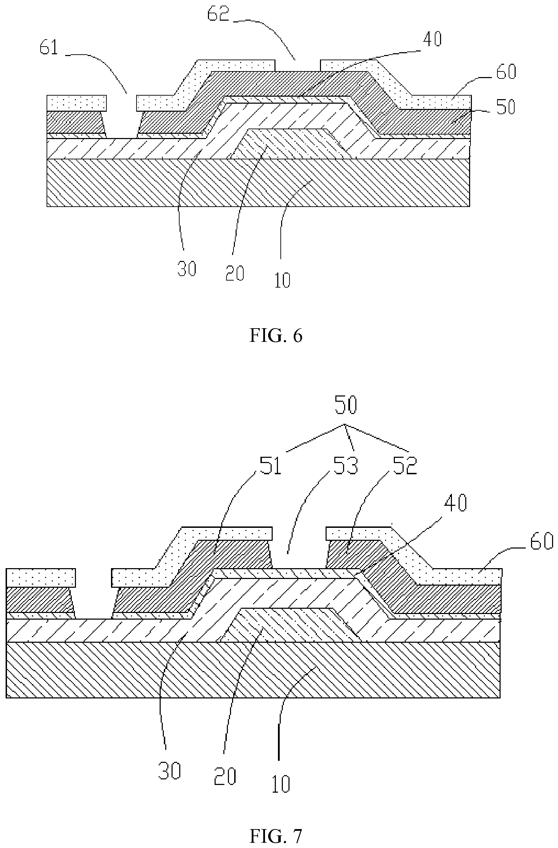

Please also referring to FIG. 6, specifically, the photoresist 60 may be ashing treated to convert the half-exposure region 62 into a full-exposure region. It can be understood that "ashing treated" is that oxygen is excited into plasma, and through the reaction of oxygen with the photoresist 60, the photoresist 60 is thinned as a whole, and the photoresist located at the half-exposure region 62 will be first removed after the photoresist 60 is thinned as a whole, that is, the half-exposure region will be converted to the full-exposure region. At this time, a portion of the metal layer 50 is exposed to the full-exposure region.

At block S0025, the portion of the etched metal layer exposed to the full-exposure region is etched to form the channel and expose the conductor buffer layer.

Referring also to FIG. 7, at this block, the source electrode 51, the drain electrode 52, and the channel 53 disposed between the source electrode 51 and the drain electrode 52 are formed at the metal layer 50. Specifically, the etchant may be sprayed on the photoresist 60, and the metal layer 50 is etched by the etchant through the full-exposure region of the photoresist 60, until the portion of the metal layer 50 located directly under the full-exposure region is completely etched to form the channel 53. The conductor buffer layer 40 is exposed to the channel 53. It can be understood that the bottom of the channel 53 is the conductor buffer layer 40 at this time. It can be understood that the channel 53 is trapezoidal. This is because the etchant diffuses into both sides of after entering the surface of the metal layer 50 through the fully exposed region 62. Furthermore, at the higher portions of the metal layer 50, the time of the metal layer 50 located directly under the full-exposure region contacting with the etchant is longer, the metal layer 50 on both sides of the channel is etched more by etchant. Therefore, the trapezoidal channel is formed at the metal layer 50.

Preferably, the etchant may be selected from a group consisting of H₂O₂, a metal chelating agent, and an organic acid.

At block S003, the portion of the conductor buffer layer exposed to the channel is semiconductorized to form a semiconductor region in the channel.

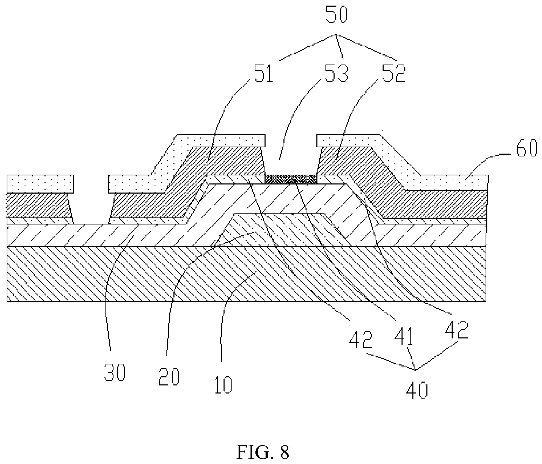

Specifically, please also referring to FIG. 8, the conductive buffer layer 40 exposed to the channel portion 41 is treated by plasma treatment or high temperature oxidation atmosphere treatment, with the photoresist layer 60 as the shielding layer. After being treated by plasma treatment or high temperature oxidation atmosphere treatment, the conductive buffer layer 40 exposed to the channel portion 41 forms the semiconductor region 41. It can be understood that the conductive property of the portion of the conductor buffer layer 40 covered by the photoresist 60 remains unchanged. Thus, the portion of the conductor buffer layer 40 covered by the photoresist 60 is still conductor regions 42. In other words, the semiconductorized conductor buffer layer 40 includes the semiconductor region 41 and the conductor regions 42.

The conductor regions 42 of the conductor buffer layer 40 are respectively connected to the source electrode 51 and the drain electrode 52. The source electrode 51 and the drain electrode 52 are electrically connected through the conductor regions 42 and the semiconductor region 41 in sequence. Thus, the metal oxide semiconductor layer of the existing array substrate structure may be omitted such that the manufacturing cost is reduced. In addition, it is not necessary to etch the conductor buffer layer during the formation of the channel, thereby reducing the etching difficulty and further reducing the manufacturing cost of the array substrate.

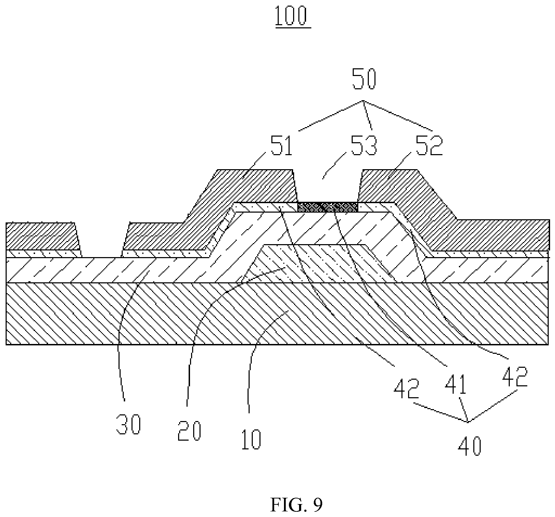

Referring to FIG. 9, after the semiconductor region 41 is formed, the photoresist 60 may be removed, and operations at subsequent blocks are continued to complete the manufacturing of the array substrate. The operations at subsequent blocks are not the protecting key points of this disclosure, and are not described in detail herein.

The photoresist 60 may be removed by a stripping process of a wet etching method. The process may be the existing photoresist stripping process, and is not described in detail herein. Alternatively, the photoresist may be removed by the ashing process described above.

In the method for manufacturing an array substrate according to the present disclosure, the source electrode, the drain electrode, and the channel disposed therebetween are formed on the metal layer, the portion of the conductor buffer layer is exposed to the channel, and the conductor buffer layer is semiconductorized to form the semiconductor region at the portion of the conductor buffer layer exposed to the channel. The source electrode and the drain electrode are electrically connected through the conductor regions and the semiconductor region in sequence. Thus, the metal oxide semiconductor layer in the existing array substrate is omitted, which reduces the manufacturing cost. In addition, it is not necessary to etch the conductor buffer layer during the formation of the channel, thereby reducing the etching difficulty and further reducing the manufacturing cost of the array substrate.

Referring to FIG. 9, the present disclosure further provides an array substrate 100. The array substrate 100 includes a gate electrode 20, a gate insulating layer 30, a conductor buffer layer 40, and a metal layer 50, stacked on the substrate 10 in sequence. The metal layer 50 includes a source electrode 51, a drain electrode 52, and a channel 53 disposed between the source electrode 51 and the drain electrode 52. The conductor buffer layer 40 includes a semiconductor region 41 and conductor regions 42. The semiconductor region 41 is exposed to the channel 53. The source electrode 51 and the drain electrode 52 face the conductor regions 42, respectively.

In the array substrate of the present disclosure, the semiconductor region of the conductor buffer layer is exposed to the channel disposed between the source electrode and the drain electrode. The source electrode and the drain electrode are electrically connected through the conductor regions and the semiconductor region of the conductor buffer layer in sequence. Thus, the metal oxide semiconductor layer in the existing array substrate structure may be omitted, which reduces the manufacturing cost. In addition, it is not necessary to etch the conductor buffer layer during the formation of the channel, thereby reducing the etching difficulty and further reducing the manufacturing cost of the array substrate.

Specifically, the channel 53 is a trapezoidal channel. This is because when the channel 53 is wet etched, the etchant diffuses into the both sides of the channel 53 after entering the surface of the metal layer 50 through the full exposure area 62. Furthermore, at the higher portions of the metal layer 50 the time of the metal layer 50 located directly under the full-exposure region 620 contacting with the etchant is longer, the metal layer 50 on both sides of the channel is etched more by etchant. Therefore, the trapezoidal channel is formed at the metal layer 50.

Optionally, the metal layer 50 may be selected from metals or alloys such as Cr, W, Cu, Ti, Ta, Mo, etc. A gate metal layer composed of a multilayer metal may also satisfy the requirement. Preferably, the metal layer 50 may be made of copper or copper alloy.

The conductor buffer layer 40 may be indium gallium zinc oxide (IGZO), HIZO, IZO, a-InZnO, a-InZnO, ZnO:F, In203:Sn, In203:Mo, Cd2SnO4, ZnO:Al. TiO2:Nb, Cd-Sn-O, or other metal oxides. Preferably, the conductor buffer layer 40 may be made of IGZO.

The embodiments of the present disclosure have been described in detail above. The principles and implementations of the present disclosure are described in the specific examples. The description of the above embodiments is only for helping to understand the method and key concepts of the present disclosure. A person skilled in the art will make changes in the specific embodiments and the scope of application according to the concept of the present disclosure. In summary, the content of the present specification should not be construed as limiting the present disclosure.

## Claims

1. A method for manufacturing an array substrate, comprising:
forming a gate electrode, a gate insulating layer, a conductor buffer layer, and a metal layer on a substrate in sequence;
patterning the metal layer and the conductor buffer layer, to form a source electrode, a drain electrode, and a channel disposed therebetween, and a portion of the conductor buffer layer being exposed to the channel; and
semiconductorizing the portion of the conductor buffer layer exposed to the channel to form a semiconductor region in the channel.

2. The method of claim 1, wherein patterning the metal layer and the conductor buffer layer, to form a source electrode, a drain electrode, and a channel disposed therebetween, and a portion of the conductor buffer layer being exposed to the channel, comprising:
coating a photoresist on the metal layer;
providing a multi-gray mask, and patterning the photoresist by the multi-gray mask to form a half-exposure region on the photoresist;
etching the metal layer and the conductor buffer layer with the photoresist as a shielding layer such that the etched metal layer and the etched conductor buffer layer have source electrode patterns and drain electrode patterns;
converting the half-exposure region on the photoresist to a full-exposure region; and
etching a portion of the etched metal layer exposed to the full-exposure region to form the channel and expose the conductor buffer layer.

3. The method of claim 2, wherein semiconductorizing the conductor buffer layer to form a semiconductor region on the portion of the conductor buffer layer exposed to the channel, comprising:
treating the portion of the conductor buffer layer exposed to the channel with the photoresist as the shielding layer by a plasma treatment or a high temperature oxidation atmosphere treatment such that the portion of the conductor buffer layer exposed to the channel forms the semiconductor region.

4. The method of claim 2, further comprising:
removing the photoresist by ashing or stripping after the semiconductor region is formed.

5. The method of claim 2, wherein converting the half-exposure region of the photoresist to a full-exposure region, comprising:
ashing the photoresist to convert the half-exposure region into the full-exposure region.

6. The method of claim 2, wherein etching the metal layer and the conductor buffer layer with the photoresist as a shielding layer such that the etched metal layer and the etched conductor buffer layer have source electrode patterns and drain electrode patterns, comprising:
etching the metal layer and the conductor buffer layer with an echant.

7. The method of claim 6, wherein the etchant is selected from a group consisting of H₂O₂, metal chelating agent, and organic acid.

8. The method of claim 2, wherein the multi-gray mask is a half-tone mask or a gray-tone mask.

9. The method of claim 1, wherein forming a gate electrode, a gate insulating layer, a conductor buffer layer, and a metal layer on a substrate in sequence, comprising:
depositing the conductor buffer layer on the gate insulating layer by sputtering or thermal evaporation.

10. The method of claim 1, wherein forming a gate electrode, a gate insulating layer, a conductor buffer layer, and a metal layer on a substrate in sequence, comprising:
depositing the gate insulating layer by a plasma enhanced chemical vapor deposition (PECVD).

11. An array substrate, comprising a gate electrode, a gate insulating layer, a conductor buffer layer, and a metal layer stacked on a substrate in sequence, the conductor buffer layer comprising a semiconductor region and conductor regions , the metal layer comprising a source electrode and a drain electrode, a channel disposed between the source electrode and the drain electrode, the source electrode and the drain electrode facing the conductor regions, and the semiconductor region exposed to the channel.

12. The array substrate of claim 11, wherein the material of the conductor buffer layer is metal oxide.

13. The array substrate of claim 12, wherein the metal oxide is IGZO.

14. The array substrate of claim 11, wherein the metal layer is made of copper or copper alloy.
